(19)

Europäisches
Patentamt
European
Patent Office
Office européen
des brevets

(11) EP 2 083 514 A2

(12) EUROPEAN PATENT APPLICATION

(43) Date of publication:
29.07.2009 Bulletin 2009/31

(51) Int Cl.:
H03C 3/09 (2006.01)

(21) Application number: 08290442.6

(22) Date of filing: 12.05.2008

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 22.01.2008 EP 08100724

(71) Applicant: NXP B.V.
5656 AG Eindhoven (NL)

(72) Inventor: **The designation of the inventor has not yet been filed**

(74) Representative: **Williamson, Paul Lewis et al
NXP Semiconductors UK Ltd
Betchworth House
Station Road
Redhill
Surrey RH1 1DL (GB)**

(54) **Signal generation**

(57) A method of operating a signal generator (500) having a phase locked loop (200) by modulating a phase locked loop (200) with a modulation signal. A scaling control signal for scaling the modulation signal is generated responsive to whether the modulation signal and an error signal of the phase locked loop (200) have the same sign.

Prior to generating the scaling control signal, filtering (30) is applied to the modulation signal mimicking the delay between a modulation signal being applied to the phase locked loop (200) and the consequent response in the error signal, as a function of frequency across the bandwidth of the phase locked loop (200).

Fig. 1

**Description**

FIELD OF THE INVENTION

The invention relates to a signal generator and to a method of operating a signal generator.

BACKGROUND TO THE INVENTION

Phase locked loops have a variety of applications, for example in frequency generation in wireless communication equipment. A basic phase locked loop comprises a variable frequency oscillator whose frequency and phase is controlled by an error signal, the error signal being generated by a phase detector that compares the phase of the oscillator output signal with the phase of a reference signal. The loop contains a low pass filter for filtering the error signal before it is applied to control the oscillator. Typically the oscillator operates at a higher frequency than the reference signal, and the loop includes a frequency divider for dividing the oscillator output signal, such that the phase detector compares the divided signal with the reference signal.

The loop performance depends, among other things, on the gain of the oscillator, the gain being a measure of the change of oscillator frequency in response to a change in the error signal. As the oscillator is typically an analogue circuit, the loop performance is susceptible to variations in analogue circuit characteristics, due to, for example, temperature or voltage changes or manufacturing process spread, which lead to variations in oscillator gain.

In a wireless transmitter, in which a carrier signal is modulated by a modulation signal, it can be advantageous to apply the modulation to a phase locked loop, rather than to a mixer which would entail an additional RF circuit. A modulation signal can be applied to the input of the oscillator and/or used to control the division ratio of the frequency divider. Schemes in which the modulation signal is applied to both the oscillator and the frequency divider are known as two-point modulation schemes. However, variations in oscillator gain will lead to variations in the modulated carrier signal. In particular, if the oscillator gain is ideal, the transfer function for the modulation from the input of the oscillator to the output of the phase locked loop, that is the output of the oscillator, is an all-pass filter. However, if the oscillator gain is too high, high frequencies of the modulation signal are amplified too much, and if the oscillator gain is too low, high frequencies of the modulation signal are amplified too little.

Therefore, it is desirable to provide a way of calibrating a phase locked loop to compensate for variations in oscillator gain. Such calibration can be performed by scaling the modulation signal applied to the input of the oscillator. Successful calibration requires appropriate control of the degree of scaling. WO 2004/034564 discloses a scheme for calibrating oscillator gain in which a correction signal is derived from a phase error signal, and in which the polarity of the error signal is measured by correlating the error signal with a modulation signal.

The present invention seeks to enable improvements in signal generation.

SUMMARY OF THE INVENTION

According to a first aspect of the invention there is provided a signal generator comprising:

a phase locked loop adapted to provide at an error signal output an error
signal indicative of a phase error between a reference signal and an oscillator signal generated by a variable frequency oscillator;
a modulation input for a modulation signal;
a first scaling stage having an input coupled to the modulation input for scaling the modulation signal in response to a scaling control signal and an output coupled to a control input of the variable frequency oscillator for controlling the frequency of the oscillator signal;
a first filter coupled to the modulation input for filtering the modulation signal to provide a filtered modulation signal; and
a scaling controller having a first input coupled to an output of the first filter and a second input coupled to the error signal output for generating the
scaling control signal dependent on the filtered modulation signal and the error signal; wherein
the first filter has a transfer function which provides a delay equal to the delay between the modulation signal being applied at the modulation input and a consequent response in the error signal at the second input of the scaling controller as a function of frequency across the bandwidth of the phase locked loop.

According to a second aspect of the invention there is provided a method for operating a signal generator having a phase locked loop, comprising:

providing an error signal indicative of a phase error between a reference signal and an oscillator signal generated by a variable frequency oscillator in the phase locked loop;
providing a modulation signal at a modulation input;
scaling the modulation signal in response to a scaling control signal;
controlling the frequency of the oscillator signal in response to the scaled modulation signal;
filtering the modulation signal with a first filter to provide a filtered modulation signal; and
coupling the filtered modulation signal to a first input of a scaling controller and the error signal to a second input of the scaling controller and generating
in the scaling controller the scaling control signal dependent on the filtered modulation signal and the error signal; wherein
the first filter has a transfer function which provides a delay equal to the delay between the modulation signal being applied at the modulation input and a consequent response in the error signal at the second input of the scaling controller as a function of frequency across the bandwidth of the phase locked loop.

Thus the invention provides an improved signal generator comprising a phase locked loop, and method for operating a signal generator having a phase locked loop, by adjusting the scaling of a modulation signal dependent on the modulation signal and the error signal, and including filtering the modulation signal with a filter that mimicks the delay, as a function of frequency, introduced by the phase locked loop.

The invention provides a scheme that can operate during normal operation of a phase locked loop without requiring dedicated time periods for calibration or a dedicated modulation signal. The scheme is independent of the spectral content of the modulation signal, such that different modulation signals can be applied without having to redesign the calibration scheme to ensure stability. This is beneficial in the current communications environment where manufacturers of communications equipment are seeking to provide multi-mode equipment capable of operating in accordance with a variety of communication standards such as GSM, Bluetooth™, DECT, and UMTS.

Optionally, the scaling controller may comprise a sign detector for generating the scaling control signal responsive to whether the sign of the filtered modulation signal relative to a first threshold value and the sign of the error signal relative to a second threshold value are the same. This can provide a simple control scheme.

Optionally, the sign detector may comprise: a first comparator for generating a first bipolar signal indicative of the sign of the filtered modulation signal relative to the first threshold value; a second comparator for generating a second bipolar signal indicative of the sign of the error signal relative to the second threshold value; and a multiplier for multiplying the first bipolar signal by the second bipolar signal. This provides a simple way of determining when the modulation signal and the error signal have the same sign.

Optionally, the scaling controller may comprise a second scaling stage for scaling the scaling control signal. This enables more precise phase locked loop calibration.

Optionally, the scaling controller may comprises a second filter for filtering the scaling control signal. This enables smoothing of the scaling control signal.

Optionally, the signal generator may comprise a third filter coupled between the error signal output and the second input of the scaling controller for filtering the error signal. This can provide noise reduction.

The invention also provides a wireless communication device comprising a signal generator according to the first aspect of the invention.

BRIEF DESCRIPTION OF THE DRAWINGS

The invention will now be described, by way of example only, with reference to the accompanying drawings in which:

Figure 1 is a block schematic diagram of a signal generator;
Figure 2 is a block schematic diagram of a wireless communication device;
Figure 3 is a diagram showing waveforms without a phase shift; and
Figure 4 is a diagram showing waveforms with a phase shift.

DETAILED DESCRIPTION OF EMBODIMENTS

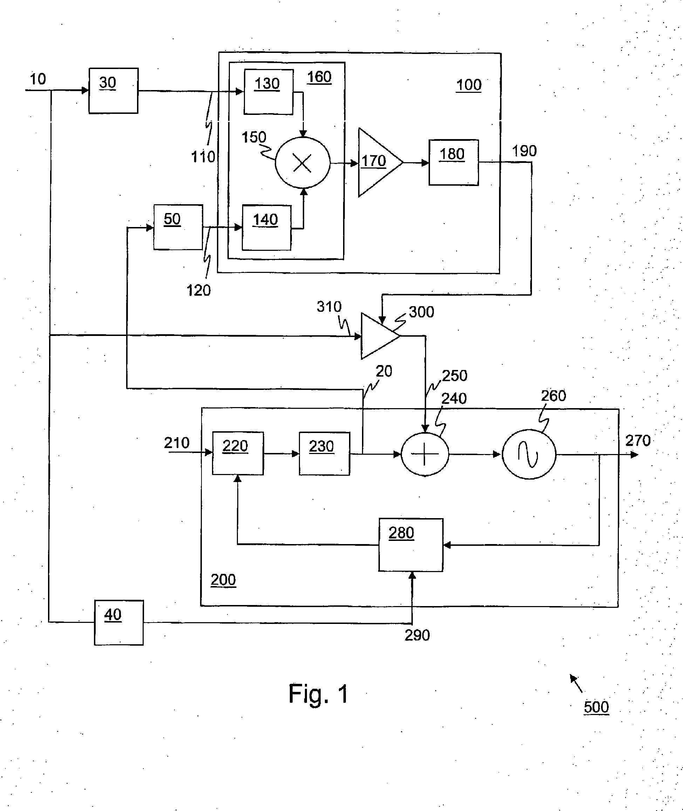

Referring to Figure 1, there is illustrated a modulation input 10 for a modulation signal and a first scaling stage 300 coupled to the modulation input 10 for scaling the modulation signal. The first scaling stage 300 may be, for example, a variable gain amplifier or may be implemented in a digital processor. The extent of scaling is controlled by a scaling controller 100 which generates a scaling control signal at an output 190 which is coupled to a control input of the first scaling stage 300. An output of the first scaling stage 300 is coupled to an input 250 of a phase locked loop 200.

The phase locked loop 200, which is known in the art, comprises a variable frequency oscillator 260 such as a voltage controlled oscillator or a digitally controlled oscillator. The variable frequency oscillator 260 provides an oscillator signal at an output 270. The output 270 is coupled to an input of a frequency divider 280 for dividing the oscillator signal. The division ratio of the frequency divider 280 can be varied in response to a signal provided at an input 290 of the frequency divider 280. The input 290 is thereby a first modulation point for modulating the variable frequency oscillator 260 with a modulation signal. The frequency divider provides the divided and modulated oscillator signal at an output which is coupled to a first input of a phase comparator 220..A second input 210 of the phase comparator 220 receives a reference signal generated by a reference oscillator (not illustrated), such as a crystal oscillator. The phase comparator 220 provides an error signal at an output which is coupled to an input of a loop filter 230. The error signal is indicative of the phase difference between the reference signal and the divided and modulated oscillator signal. The filtered error signal is coupled to a first input of a summing stage 240. The input 250 of the phase locked loop 200 is coupled to a second input of the summing stage 240 and so receives the scaled modulation signal from the first scaling stage. The summing stage 240 provides the sum of the filtered error signal and the modulation signal at an output which is coupled to an input of the variable frequency oscillator 260 for controlling its frequency. The input 250 of the phase locked loop 200 thus provides a second modulation point for modulating the variable frequency oscillator 260.

The summing stage 240 may be implemented in various ways. For example, for an analogue phase locked loop it may sum voltages, and for a digital phase locked loop it may sum digital codes. A further possibility is for the inputs ofthe summing stage 240 to directly drive independent varicaps, or capacitor banks, in which case the resulting sum is the sum of capacitance values.By controlling the extent of scaling by the first scaling stage 300, variations in the gain of the variable frequency oscillator 260 can be compensated.

In a variation of the architecture described above and illustrated in Figure 1, the first scaling stage 300, instead of being coupled between the modulation input 10 and the input 250 of the phase locked loop 200, may alternatively be coupled between the output of the summing stage 240 and the input of the variable frequency oscillator 260. In this position, both modulation signal and the filtered error signal are scaled by the first scaling stage. This architecture is advantageous if the signal generator 500 is to be operated some of the time without being modulated by a modulation signal; in this case the modulation may be used temporarily for calibration by determining the required scaling control signal, and then operation continues without modulation and with the scaling control signal held at the determined value.

Turning now to the scaling controller 100, it has a first input 110 coupled to the modulation input 10 by means of a first filter 30 for filtering the modulation signal. The scaling controller 100 has a second input 120 coupled to receive the error signal from the phase locked loop 200. The error signal may be extracted from the phase locked loop 200 at the output of the loop filter 230 as illustrated in Figure 1, or at the output of the phase comparator 220. Further filtering may be applied to the error signal by means of an optional second filter 50 coupled between the phase locked loop 200 and the second input 120 of the scaling controller 100. The scaling controller 100 derives the scaling control signal from the signals present at its inputs 110, 120, and delivers the scaling control signal at its output 190.

Before describing embodiments of the scaling controller 100, some principles underlying the scaling control will be described. The error signal u(s) of a phase locked loop may be expressed as

$$u(s) = \frac{1}{2\pi K_0} . \frac{1-k}{1+\dfrac{1}{L(s)}} . w_m(s) \qquad\qquad (1)$$

where s is the Laplace operator, k is the oscillator gain, $K_0$ is a constant, L(s) is the open loop transfer function, and $w_m$(s) is the modulation signal. Ideally, k=1, so 1-k represents the gain error. As an initial approximation, assume that L(s) is large, so that $1 + 1/L(s) \approx 1$. Therefore,

$$u(s) = \frac{1-k}{2\pi K_0} . w_m(s)$$

If the error signal u(s) has the same sign as the modulation signal $w_m$(s), then the gain error *1*-k is positive, which indicates that the oscillator gain is less than one, so is too small. If the error signal u(s) has the opposite sign to the modulation signal w(s), then the gain error 1-k is negative, which indicates that the oscillator gain is greater than one, so is too large. It is apparent from equation (1) that

$$\text{sign (u) = sign(1-k).sign (w}_m)$$

where the Laplace operator has been omitted because this is applicable in either the time domain or frequency domain. Thus it can be determined, from the sign of the error signal and the modulation signal, whether the gain is too small or too large by evaluating:

$$\text{sign (u).sign (w}_m) = \text{sign(1-k).sign}^2(w_m)$$

$$\text{i.e. sign (u).sign (w}_m) = \text{sign(1-k)} \qquad\qquad (2)$$

because $\text{sign}^2(w_m)=1$.

The approximation that L(s) is large is valid at low frequencies where the loop gain is high. However, at high frequencies where the loop gain is lower it is possible that the error signal is delayed by 90 degrees with respect to the modulation signal. In this case, multiplying signals that are 90 degrees apart results in a zero average, and not in a valid indication of gain error.

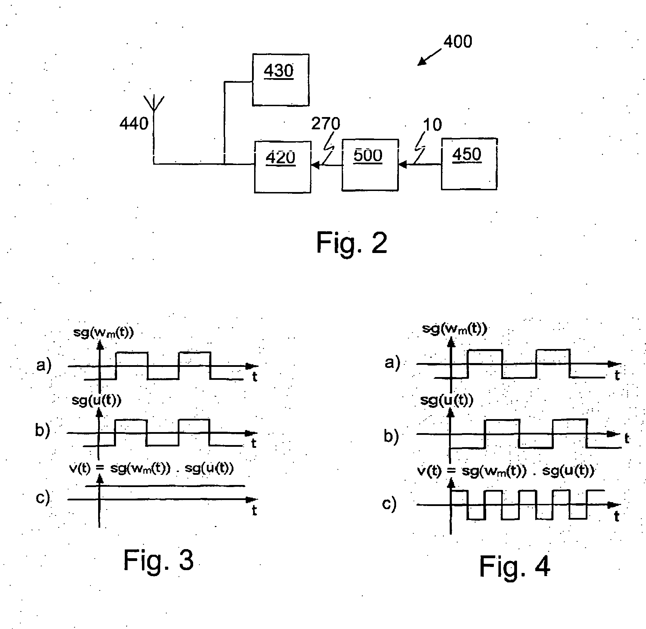

This problem is readily illustrated by means of waveform diagrams. In Figures 3 and 4, "sg" is an abbreviation for the sign function, $w_m(t)$ represents the modulation signal as a function of time t, and u(t) represents the error signal as a function of time. Figure 3 illustrates a situation in which the modulation signal and the error signal are in-phase, resulting in the product v(t) of their signs being positive. Therefore, according to equation (2), the oscillator gain k is too small. Figure 4 illustrates a situation in which the modulation signal and the error signal are 90 degrees out of phase, resulting in the product v(t) of their signs alternating between positive and negative values, and which if averaged would have a mean value of zero. Therefore, in this case a valid indication of whether k is too large or too small is not generated. As the phase difference approaches 90 degrees, the indication decreases to zero and so becomes progressively unreliable. If the phase difference approaches 180 degrees, the error signal changes sign and an erroneous indication of whether k is too large or too small is generated.

The analysis above demonstrates that the relative phase, or delay, of the modulation signal and the error signal affects the reliability of calibration.

According to the invention, the first filter 30 has a transfer function which provides a delay equal to the delay between the modulation signal applied at the modulation input 10 and a consequent response in the error signal at the second input 120 of the scaling controller 100 as a function of frequency across the bandwidth of the phase locked loop 200. This provides a calibration scheme which is independent of the spectral content of the modulation signal. In its simplest form, the error signal output 20 of the phase locked loop is coupled directly to the second input 120 of the scaling controller 100, in which case the transfer function of the first filter 30 mimics the transfer function of the phase locked loop 200, that is the delay, as a function of frequency, between providing a modulation signal at the modulation input 10 and the resulting changing the error signal at the second input 120 of the scaling controller 100.

In a variation, it may be advantageous to provide further filtering of the error signal by means of the optional second filter 50 in order to reduce noise. In this case, any delay introduced by the second filter 50 should also be applied to the modulation signal as well. In this case, the transfer function of first filter 30 corresponds to the combination of the transfer function of the phase locked loop 200 plus the transfer function of the second filter 50. Such a combination may be implemented as a single filter or a combination of more than one filter.

By filtering the modulation signal as described above, a valid indication can be generated of whether the gain k of the oscillator is too small or too large, and independent of the spectral content the modulation signal.

The scaling controller 100 comprises a sign detector 160 having inputs coupled to the first input 110 and the second input 120 and which generates an indication of whether the modulation signal and the error signal have the same sign, relative to, respectively, a first threshold value and a second threshold value.

The sign detector 160 comprises a first comparator 130 coupled to the first input 110 for comparing the modulation signal, after filtering by the first filter 30, with the first threshold value, and for providing at an output of the first comparator 130 a first sign signal indicative of whether the modulation signal is greater than or less than the first threshold. Preferably any DC component of the modulation signal is removed, in which case the first threshold value can be zero. The first sign signal provided at the output of the first comparator 130 is a bipolar signal, and preferably has a value +1 or -1 according to whether the modulation signal is greater than or less than the first threshold.

There is a second comparator 140 coupled to the second input 120 for comparing the error signal, after any filtering applied by the second filter 50, with the second threshold value, and for providing at an output of the second comparator 140 a second sign signal indicative of whether the error signal is greater than or less than the second threshold. Preferably any DC component of the error signal is removed, in which case the second threshold value can be zero. The second sign signal provided at the output of the second comparator 140 is a bipolar signal, and preferably has a value +1 or -1 according to whether the error signal is greater than or less than the second threshold.

The output of the first comparator 130 and the output of the second comparator 140 are coupled to respective inputs of a multiplier 150 which multiplies the first and second sign signals and provides at an output an indication of whether the first and second sign signals have the same sign, thereby providing an indication of whether the modulation signal and the error signal have the same sign relative to their respective first and second threshold values. If the first and second sign signals can both have values +1 and -1, the indication at the output of the multiplier 25 will have a value +1 if both sign signals have the same value, in which case the scaling control signal causes the scaling factor applied to the modulation signal by the first scaling stage 300 to increase, and a value -1 if the sign signals have different values, in which case the scaling control signal causes the scaling factor applied to the modulation signal by the first scaling stage 300 to decrease.

The embodiment of the scaling controller 100 illustrated in Figure 1 also includes an optional second scaling stage 170 coupled to the output of the sign detector 160 for scaling the scaling control signal provided to the output of the scaling controller 100, and an optional third filter 180 arranged to filter the the scaling control signal provided to the output of the scaling controller 100. These elements enable, respectively, precise setting of the scaling control signal magnitude, and smoothing and noise reduction of the scaling control signal.

Optionally, the processing provided by the first filter 30, the second filter 50 and the scaling controller 100 may be provided only intermittently, when calibration of the gain in the phase locked loop 200 is required, thereby conserving power. In this case, when the signal generator 500 remains operational but the calibration is not taking place, the scaling control signal is held at a constant value, as determined during the preceding calibration.

The signal generator 500 illustrated in Figure 1 has its input 290, which serves as a first modulation point, coupled to the modulation input 10 by means of a fourth filter 40, which may be a low pass filter. In this way the division ratio of the frequency divider 280 is varied in response to the modulation signal. Alternatively, the reference signal may be modulated prior to being applied to the second input 210 of the phase comparator 220. In this latter case the frequency divider 280 may have a fixed division ratio, or may even be omitted, the output 270 being coupled to the phase comparator 220 undivided.

Elements of the signal generator 500, and in particular the first filter 30, the second filter 50, the scaling controller 100 and the scaling stage 300 may be implemented in analogue or digital hardware or in software executed by a processor.

Other embodiments of the scaling controller 100 may be used. For example, although embodiments have been described which use bipolar signals, alternatively other types of signals may be used, in particular multilevel signals, analogue signals, or monopolar signals. In particular, the use of first and second comparators 130, 140 that output binary values is not essential, but merely enables a simple implementation. Instead, the modulation signal and/or the error signal may be processed as analogue signals or multi-value digital signals. The indication at the output of the sign detector 160 can have any form, such as an analogue signal or a digital value, and need not be a two level signal as described in relation to the embodiment of Figure 1.

Referring to Figure 2, there is illustrated a block schematic diagram of a wireless communication device 400, such as a mobile telephone, comprising a baseband processor 450 for generating a modulation signal, a signal generator 500 as illustrated in Figure 1 and described above, and a transmitter 420 having an output coupled to an antenna 440, and a receiver 430 having an iniput coupled to an antenna 440. An output of the baseband processor 450 is coupled to the modulation input 10 of the signal generator 500 for providing a modulation signal to the signal generator 500, and the output 270 of the signal generator 500 is coupled to an input of the transmitter 420.

Elements of the invention may be implemented using a processor, digital signal processor (DSP) or central processing unit (CPU) providing the same functionality. Similarly, elements of the invention could be implemented using a hard-wired circuit or circuits, such as an application-specific integrated circuit (ASIC), or embedded software. Indeed, elements of the invention can be implemented using computer program code or computer software. Such computer software or computer program code can be carried by a computer readable medium. The medium may be a physical storage medium such as a Read Only Memory (ROM) chip. Alternatively, it may be a disk such as a Digital Versatile Disk (DVD-ROM) or Compact Disk (CD-ROM). It could also be a signal such as an electronic signal over wires, an optical signal or a radio signal such as to a satellite or the like.

From reading the present disclosure, other variations and modifications will be apparent to the skilled person. Such variations and modifications may involve equivalent and other features which are already known in the art of signal generators and phase locked loops, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

**Claims**

1. A signal generator (500) comprising:

   a phase locked loop (200) adapted to provide at an error signal output (20) an error signal indicative of a phase error between a reference signal and an oscillator signal generated by a variable frequency oscillator (260);
   a modulation input (10) for a modulation signal;
   a first scaling stage (300) having an input coupled to the modulation input (10) for scaling the modulation signal in response to a scaling control signal and an output coupled to a control input of the variable frequency oscillator (260) for controlling the frequency of the oscillator signal;
   a first filter (30) coupled to the modulation input (10) for filtering the modulation signal to provide a filtered modulation signal; and
   a scaling controller (100) having a first input (110) coupled to an output of the first filter (30) and a second input (120) coupled to the error signal output (20) for generating the scaling control signal dependent on the filtered modulation signal and the error signal; wherein
   the first filter (30) has a transfer function which provides a delay equal to the delay between the modulation signal being applied at the modulation input (10) and a consequent response in the error signal at the second input (120) of the scaling controller (100) as a function of frequency across the bandwidth of the phase locked loop (200).

2. A signal generator (500) as claimed in claim 1, wherein the scaling controller (100) comprises a sign detector (160) for generating the scaling control signal responsive to whether the sign of the filtered modulation signal relative to a first threshold value and the sign of the error signal relative to a second threshold value are the same.

3. A signal generator (500) as claimed in claim 2, wherein the sign detector (160) comprises:

   a first comparator (130) for generating a first bipolar signal indicative of the sign of the filtered modulation signal relative to the first threshold value;
   a second comparator (140) for generating a second bipolar signal indicative of the sign of the error signal relative to the second threshold value; and
   a multiplier (150) for multiplying the first bipolar signal by the second bipolar signal.

4. A signal generator (500) as claimed in claim 1, 2 or 3, wherein the scaling controller (100) comprises a second scaling stage (170) for scaling the scaling control signal.

5. A signal generator (500) as claimed in any preceding claim, wherein the scaling controller (100) comprises a second filter (180) for filtering the scaling control signal.

6. A signal generator (500) as claimed in any preceding claim, comprising a third filter (50) coupled between the error signal output (20) and the second input (120) of the scaling controller (100) for filtering the error signal.

7. A signal generator (500) as claimed in any preceding claim, wherein the phase locked loop (200) comprises:

   a coupling stage (240) for coupling the scaled modulation signal and the error signal to the variable frequency oscillator (260) for controlling the frequency of the oscillator signal.

8. A signal generator (500) as claimed in any one of claims 1 to 6, wherein the phase locked loop (200) comprises:

   a coupling stage (240) for coupling the modulation signal and the error signal to the input of the first scaling stage (300).

9.  A signal generator (500) as claimed in claim 7 or 8, wherein the phase locked loop is adapted to provide at the error signal output (20) the error signal filtered by the loop filter (230).

10. A signal generator (500) as claimed in any preceding claim, wherein the phase locked loop (200) comprises a frequency divider (280) for dividing the oscillator signal, and wherein the error signal is indicative of a phase difference between the divided oscillator signal and the reference signal.

11. A signal generator (500) as claimed in claim 10, wherein the frequency divider (280) is adapted to divide the oscillator signal using a variable division ratio, and the frequency divider (280) comprises an input (290) for varying the division ratio in response to the modulation signal.

12. A wireless communication device (400) comprising a signal generator as claimed in any one of claims 1 to 11.

13. A method for operating a signal generator (500) having a phase locked loop (200), comprising:

    providing an error signal indicative of a phase error between a reference signal and an oscillator signal generated by a variable frequency oscillator (260) in the phase locked loop;
    providing a modulation signal at a modulation input (10);
    scaling the modulation signal in response to a scaling control signal;
    controlling the frequency of the oscillator signal in response to the scaled modulation signal;
    filtering the modulation signal with a first filter (30) to provide a filtered modulation signal; and
    coupling the filtered modulation signal to a first input (110) of a scaling controller (100) and the error signal to a second input (120) of the scaling controller (100) and generating in the scaling controller (100) the scaling control signal dependent on the filtered modulation signal and the error signal; wherein
    the first filter (30) has a transfer function which provides a delay equal to the delay between the modulation signal being applied at the modulation input (10) and a consequent response in the error signal at the second input (120) of the scaling controller (100) as a function of frequency across the bandwidth of the phase locked loop (200).

14. A method as claimed in claim 13, wherein the scaling control signal is dependent on whether the filtered modulation signal applied at the first input (110) of the scaling controller (100) and the error signal applied at the second input (120) of the scaling controller (100) have the same sign.

Fig. 1

Fig. 2

Fig. 3

Fig. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• WO 2004034564 A